Europäisches Patentamt

European Patent Office

Office européen des brevets

(19)

(11) Veröffentlichungsnummer: **0 046 886**

**A2**

(12) # EUROPÄISCHE PATENTANMELDUNG

(21) Anmeldenummer: 81106010.2

(22) Anmeldetag: 30.07.81

(51) Int. Cl.³: **H 01 L 21/82**
**H 01 L 21/265, H 01 L 27/10**
**G 11 C 11/24**

(30) Priorität: 29.08.80 DE 3032632

(43) Veröffentlichungstag der Anmeldung:
**10.03.82 Patentblatt 82/10**

(84) Benannte Vertragsstaaten:
**FR GB**

(71) Anmelder: SIEMENS AKTIENGESELLSCHAFT Berlin
und München
Postfach 22 02 61
D-8000 München 22(DE)

(72) Erfinder: Schulte, Heinz, Dipl.-Phys.
Mauthäuslstrasse 17
D-8000 München 70(DE)

(54) Verfahren zur Herstellung integrierter dynamischer RAM-Eintransistorspeicherzellen.

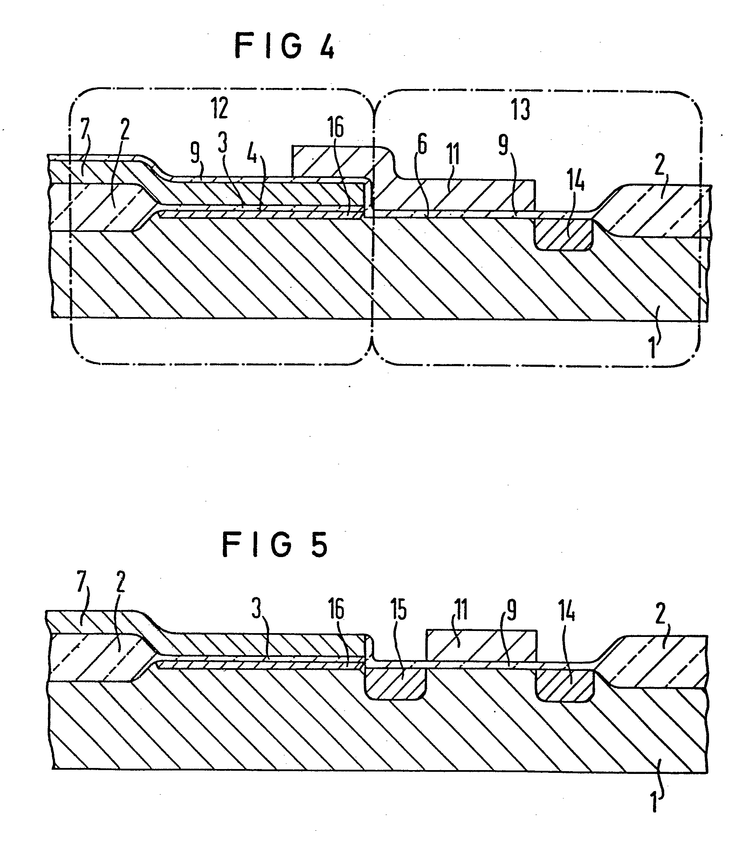

(57) Es wird ein Verfahren zur Herstellung von in einem Halbleiterchip (1) integrierten dynamischen RAM-Eintransistorzellen, bestehend aus einem Varaktor, dargestellt durch Teil (12), und einem integrierten Feldeffekttransistor, dargestellt durch Teil (13), angegeben, bei dem die Varaktorkapazität durch Implantation einer geeigneten p-n-Kapazität erhöht wird und der Flächenbedarf am Chip mittels Einführung selbstjustierender Maßnahmen herabgesetzt wird. Das erfindungsgemäße Verfahren läßt sich zur Herstellung dynamischer RAM-Speicher, insbesondere 64 k RAM-Speicher verwenden (Fig. 4).

FIG 4

SIEMENS AKTIENGESELLSCHAFT
Berlin und München

Unser Zeichen
VPA 80 P 1 1 4 2 E

0046886

Verfahren zur Herstellung integrierter dynamischer RAM-Eintransistorspeicherzellen.

Die Erfindung betrifft ein Verfahren zur Herstellung von in einem Halbleiterchip integrierten dynamischen RAM-Eintransistorspeicherzellen, bestehend aus je einem integrierten Feldeffekttransistor und je einem integrierten Varaktor, bei dem mittels fotolithografisch vorgegebenem Muster an einer Halbleiteroberfläche die Oxidstrukturen in an sich bekannter Weise z.B. mittels Locos-Verfahren angebracht werden.

Bei der Herstellung derartiger Speicherzellen ist man bemüht, möglichst hohe Varaktorkapazitäten zu erzeugen und außerdem den Flächenbedarf am Chip zu verringern.

Zur Schaffung möglichst hoher Varaktorkapazitäten wird gewöhnlich schwach dotiertes Halbleitersubstrat verwendet und unter dem Varaktor die Isolatorkapazität möglichst groß gemacht, was jedoch im allgemeinen zu einer relativ kleinen Isolatorschichtdicke führt. Varaktorstrukturen und Feldeffekttransistorstrukturen werden mittels fotolithografischer Verfahren in den Halbleiterkörper eingebracht. Bei fotolithografischen Verfahren sind jedoch gewisse Justiertoleranzen vorgegeben, die nicht unterschritten werden können. Hiermit erzeugte Eintransistorzellen fordern somit am Halbleiterchip einen gewissen Platzbedarf, der sich wegen der Justiertoleranzen der fotolithografischen Prozesse nicht maßgeblich verringern läßt. Da aber der Platzbedarf von Speicherzellen auf einem Chip ein wesentlicher Faktor für deren Verwendung beim Bau von Speichern ist, ist es wünschenswert, diesen zu reduzieren.

Kus 1 Lk / 26.8.1980

0046886

Aufgabe der vorliegenden Erfindung ist daher ein Verfahren zur Herstellung von in einem Halbleiterchip integrierten dynamischen RAM-Eintransistorzellen anzugeben, welches sowohl einen geringen Platzbedarf derartiger Speicherzellen als auch eine hohe Kapazität der Varaktoren gewährleistet.

Diese Aufgabe wird mittels Locos-Verfahren erfindungsgemäß dadurch gelöst, daß eine erste Ionenimplantation so erfolgt, daß die Dickoxidbereiche als Implantationsmaske dienen und daß zunächst eine erste Ionensorte ganzflächig implantiert wird, daß danach eine erste Schicht von polykristallinem Halbleitermaterial ganzflächig auf der Oberfläche abgeschieden wird, daß danach die erste polykristalline Schicht mittels einer vorgegebenen Fotolackmaske strukturiert wird, daß an den freien Stellen der Fotolackmaske die darunter liegenden Schichten, die polykristalline Schicht, die Oxidschicht und, falls die erste Implantation in eine oberflächennahe Halbleiterschicht erfolgt, auch diese Halbleiterschicht, abgeätzt werden, daß danach die Fotolackmaske abgelöst wird, daß danach eine ganzflächige Oxidation sowohl der freien Halbleiteroberflächenteile wie der polykristallinen Halbleiterschicht erfolgt, daß danach eine zweite bezüglich der Kanten der ersten polykristallinen Halbleiterschicht selbstjustierende, ganzflächige Ionenimplantation erfolgt, daß danach eine zweite polykristalline Schicht ganzflächig abgeschieden wird, daß danach die zweite polykristalline Halbleiterschicht durch eine geeignete Fototechnik strukturiert wird.

Dieses Verfahren hat den Vorteil, daß die Strukturen wegen der selbstjustierenden ersten Implantation sehr klein gehalten werden können und dadurch der Platzbedarf am Chip gering ist. Ein weiterer Vorteil des erfindungsgemäßen Verfahrens liegt in der Verbesserung der Varaktorkapazität, da durch dieses Verfahren zur Oxidkapazität eine parallel geschaltete p-n-Kapazität im Halbleiterinneren dadurch entsteht, daß die mittels der ersten Implantation unter der Varaktoroxidschicht implantierten Ionen durch nachfolgende Temperaturschritte, wie das durch nachfolgende Oxidationen der Halbleiteroberfläche gegeben ist, in den Halbleiterkörper eindiffundieren und im Inneren dort einen p-n-Übergang schaffen.

Es ist auch erfinderisch, daß die zweite polykristalline Halbleiterschicht so strukturiert wird, daß eine zusätzliche Diffusion oder Implantation in den Halbleitereinkristall selbstjustierend bezüglich der Kanten der zweiten polykristallinen Halbleiterschicht und Kanten des Dickoxids sowie möglicherweise auch bezüglich Kanten der ersten polykristallinen Halbleiterschicht erfolgt.

Diese Maßnahme ist besonders vorteilhaft, wenn unterhalb der ersten polykristallinen Schicht eine zusätzliche p-n-Kapazität eingebracht werden soll. Die Tatsache, daß die Diffusion bzw. Implantation dieser Gebiete selbstjustierend zu darüber abgelagerten polykristallinen Schichten erfolgt, hat wiederum den Vorteil, Justiertoleranzen einzusparen und dadurch den Platzbedarf am Chip herabzusetzen.

Je nach Erfordernissen der zu fertigenden Bauteile ist es vorteilhaft, daß die Dotierung der ersten und zweiten polykristallinen Schicht während oder nach der Abscheidung dieser Schichten erfolgt.

Es ist des öfteren auch vorteilhaft, daß die erste Implantation in den Halbleitereinkristall oder aber in eine auf den zu implantierenden Bereichen abgescheidene Oxidschicht mit nachfolgender Diffusion der implantierten Ionen in den Halbleiterkristall erfolgt.

Durch diese Maßnahme können die implantierten Ionen bei nachfolgenden Temperaturschritten wie z.B. bei der Oxidation in die darunter liegenden Halbleiterbereiche eindiffundiert werden, wodurch gleichzeitig das Diffusionsprofil dieser Ionen im Halbleiterkörper schmal gehalten werden kann, während bei Diffusion in dem Halbleiterkörper
alle nachfolgenden Temperaturschritte das Diffusionsprofil aufweiten. Außerdem braucht in diesem Falle bei der
strukturierten Oberflächenätzung, die vor der zweiten Implantation erfolgt, lediglich die polykristalline Schicht
und die Oxidschicht entfernt zu werden. Dadurch bleibt
die Halbleiteroberfläche im Bereich der Varaktoren sowie
der MOS-Transistoren annähernd eben, was Vorteile bei
der fotolithografischen Strukturerzeugung hat.

Es ist auch erfinderisch, daß die erste Ionenimplantation in den zu dotierenden Halbleiterbereichen
einen Leitungstyp einer ersten Art erzeugt, während die
zweite Ionenimplantation in den zu dotierenden Bereichen
einen Leitungstyp einer zweiten Art erzeugt, der dem Leitungstyp der ersten Art entgegengerichtet ist. Durch die
Wahl dieser Implantation lassen sich z.B. erfindungsgemäße Varaktoren und MOS-Transistoren räumlich eng nebeneinander abscheiden.

Es ist auch vorteilhaft, daß als Halbleitermaterial Silicium verwendet wird. Die Verwendung von Silicium als Halbleitermaterial hat den Vorteil, daß auf diesem Gebiet
ausgereifte und erprobte Arbeitsverfahren vorliegen, weshalb hiernach gefertigte Bauelemente technisch einfach
und kostensparend hergestellt werden können.

Es ist auch vorteilhaft, daß als einkristallines Halbleitermaterial p-leitendes Silicium und zur ersten Implantation eine Ionenart mit kleinen Diffusionskoeffizienten
aus der fünften Gruppe des periodischen Systems, z.B.
Arsen verwendet wird, während zur zweiten Implantation eine Ionenart aus der dritten Gruppe des periodischen Systems, z.B. Bor, verwendet wird. Die Verwendung von Ionenarten mit kleinem Diffusionskoeffizienten bei der ersten Implantation hat den Vorteil, daß einmal im Halbleiterkristall gebildete Diffusions- bzw. Implantationsprofile durch nachfolgende Temperaturschritte nicht so stark aufgeweitet werden.

Nachfolgend wird die Erfindung anhand der Zeichnung und an Ausführungsbeispielen näher erläutert. Es zeigen:

Fig. 1 ein mit Dickoxidstrukturen versehenes Halbleitersubstrat,

Fig. 2 ein Halbleitersubstrat wie Fig. 1 mit strukturierter erster polykristalliner Schicht,

Fig. 3 ein Halbleitersubstrat wie Fig. 2 mit Oxidüberzug und einem ersten dotierten Bereich,

Fig. 4 ein Halbleitersubstrat wie Fig. 3 mit strukturierter zweiter polykristalliner Schicht und einem zweiten dotierten Bereich,

Fig. 5 ein Halbleitersubstrat wie Fig. 3 mit einer zweiten strukturierten polykristallinen Schicht und einem dritten dotierten Bereich.

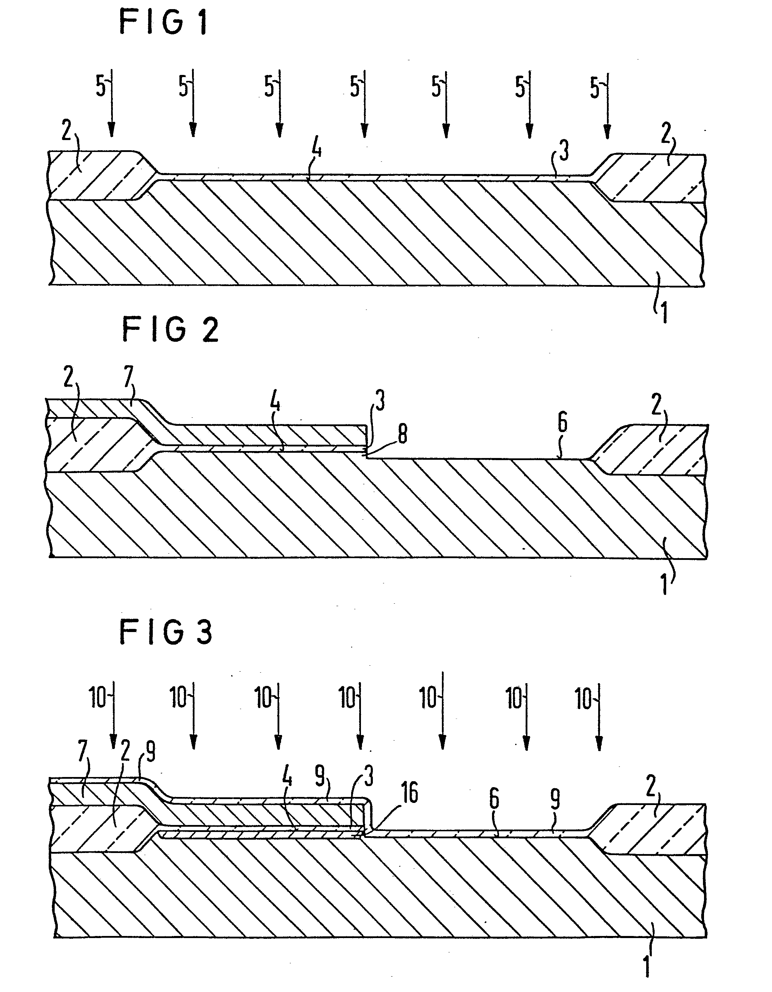

Fig. 1 zeigt ein Halbleitersubstrat 1, auf welchem Dickoxidstrukturen 2 und dünne Oxidschichten 3 an der Oberfläche 4 angebracht sind. Die Pfeile 5 deuten eine erste Implantation an, die entweder in die dünnen Oxidschichten 3 oder in oberflächennahe Schichten des Halbleitersubstrats 1 erfolgen kann. Bei der Verwendung von p-leitendem Silicium als Halbleitersubstrat 1 kann bei der ersten Implantation z.B. eine Depletionimplantation mittels Arsen erfolgen.

In den folgenden Figuren sind gleiche Gegenstände mit gleichen Bezugszeichen wie in Fig. 1 belegt, weshalb diese nicht nochmals beschrieben werden.

Fig. 2 zeigt ein Halbleitersubstrat 1 wie Fig. 1, bei dem nach der ersten Implantation zunächst ganzflächig eine polykristalline, dotierte erste Siliciumschicht abgeschieden wird, die anschließend z.B. mittels Fototechnik so strukturiert wird, daß die strukturierte polykristalline Siliciumschicht 7 resultiert. Bei dieser Strukturierung werden an den z.B. mittels Plasmaätzung freigeätzten Siliciumoberflächenteilen 6 die darüber befindliche erste polykristalline Schicht abgetragen, sowie die dünne Oxidschicht 3 abgetragen. Erfolgt die erste Implantation in oberflächennahe Schichten des Halbleitersubstrates, so werden diese oberflächennahen Schichten, die außerhalb der strukturierten polykristallinen Siliciumschicht 7 liegen, mit den anderen Schichten z.B. mittels Plasmaätzung entfernt. Die dadurch entstehenden Siliciumoberflächenteile 6 weisen einen Niveauunterschied gegenüber der ursprünglichen Oberfläche 4 auf, was durch die Stufe 8 angedeutet ist. Bei Implantation in die dünne Oxidschicht 3, wird diese lediglich entfernt, weshalb die Stufe 8 nicht entsteht. Die Abscheidung und Dotierung der ersten polykristallinen Siliciumschicht erfolgt vorteilhaft bei so niedrigen Temperaturen (ca. 500°C), daß eine Ausdiffusion der ersten Implantation aus dem Oxid ins Halbleitersubstrat zunächst unterbleibt.

Fig. 3 zeigt ein Halbleitersubstrat 1 wie Fig. 2, auf dem ganzflächig eine dünne Oxidschicht 9 abgeschieden ist. Erfolgt die Aufbringung dieser Oxidschicht durch thermische Oxidation z.B. bei 1000°C, so diffundieren dabei die Ionen der ersten Implantation aus der verbliebenen Oxidschicht 3 bzw. aus den oberflächennahen Schichten des Halbleitersubstrats 1 unterhalb der verbliebenen Oxidschichten 3, ins Innere des Halbleitersubstrats 1 und bilden dort den ersten dotierten Bereich 16. Die Pfeile 10 deuten eine zweite Implantation an, die entweder in die dünne Oxidschicht 9 oder in oberflächennahe Schichten des Halbleitersubstrats 1 unterhalb der Siliciumoberflächenteile 6 erfolgt. Diese Implantation kann z.B. eine Enhancementimplantation sein, und mittels Bor erfolgen.

Fig. 4 zeigt ein Halbleitersubstrat 1 wie Fig. 3, auf welchem eine zweite polykristalline, dotierte und strukturierte Siliciumschicht 11 aufgebracht ist. Die Dotierung der polykristallinen Siliciumschicht 11 kann entweder während des Abscheideprozesses oder danach erfolgen. Die polykristalline Siliciumschicht 11 wird zunächst wiederum ganzflächig aufgebracht und anschließend z.B. mittels Fototechnik so strukturiert, daß ein zweiter dotierter Bereich 14 selbstjustierend in das Halbleitersubstrat 1 eingebracht ist. Die Struktur nach Fig. 4 kann bereits als Eintransistorzelle eines dynamischen integrierten Halbleiterspeichers fungieren, wobei der strichpunktiert angedeutete Teil 12 einen Varaktor darstellt, mit den Anschlüssen zwischen der polykristallinen dotierten Siliciumschicht 7 und dem Halbleitersubstrat 1 und der strichpunktiert angedeutete Teil 13 einen MOS-Feldeffekttransistor darstellt. Die polykristalline dotierte Siliciumschicht 11 bildet dabei das Gate.

Fig. 5 zeigt ein Halbleitersubstrat 1 wie Fig. 4, bei dem die polykristalline dotierte Siliciumschicht 11 so strukturiert ist, daß ein dritter dotierter Bereich 15 in das Halbleitersubstrat 1 selbstjustierend eingebracht ist.

Je nach den Anforderungen werden MOS-Speicherzellen entsprechend Fig. 4 oder Fig. 5 gefertigt. Die dotierten Bereiche 14 und 15 bzw. 16 dienen dabei als Source- und/oder Drain-Bereiche.

Zur Durchführung des erfindungsgemäßen Verfahrens kann vorzugsweise als Halbleitersubstrat ein p-dotiertes Siliciumsubstrat verwendet werden. Es lassen sich jedoch auch andere Halbleitermaterialien und die spiegelbildliche

0046886

80 P 1142 E

Dotierung verwenden. Nach Aufbringung von Locosstrukturen, wie in Fig. 1 dargestellt, erfolgt zunächst die erste Implantation, die zur Erzeugung der p-n-Kapazität in den Varaktoren dient. Bei p-dotiertem Siliciumsubstrat kann vorzugsweise mittels Arsenionen implantiert werden. Für die Auswahl der Ionenart ist wichtig, daß sie einen kleinen Diffusionskoeffizienten hinsichtlich des verwendeten Halbleitermaterials aufweist. Nach der ersten Implantation wird die erste Polysilisiumschicht zunächst ganzflächig abgeschieden. Das kann durch Zersetzen von Siliciumwasserstoff bei ca. 500°C und anschließender Ablagerung von Silicium auf der Halbleiteroberfläche erfolgen. Um dotiertes Polysilicium zu erhalten, kann z.B. Arsen dem Reaktionsgefäß zugeführt werden, so daß sich sofort eine dotierte Polysiliciumschicht abscheidet. Die Dotierung der Polysiliciumschicht kann jedoch auch nachträglich durch Implantation erfolgen. Danach erfolgt die in Fig. 2 dargestellte erste Strukturierung der Polysiliciumschicht 7. Soll dabei an gewissen Teilen des Chips nur die Polysiliciumschicht und die darunter liegende dünne Oxidschicht entfernt werden, die Siliciumsubstratoberfläche hingegen nicht angegriffen werden, so empfiehlt es sich, die Polysiliciumschicht z.B. mittels Plasmaätzen zu entfernen, während die Siliciumoxidschicht naßchemisch entfernt wird. Vor der Plasmaätzung kann dabei eine Ätzmaske z.B. bestehend aus Fotolack aufgebracht werden, während für den naßchemischen Vorgang die verbleibenden Polysiliciumschichten als Maske dienen. Im Falle einer erfolgten Implantation in das Halbleitersubstrat muß hingegen auch ein oberflächennaher Teil der Halbleitersubstratschicht mitentfernt werden. In diesem Falle und bei Verwendung von Silicium als Halbleitermaterial kann ein Plasmaätzverfahren zur Ätzung der drei Materialien Polysilicium, Siliciumoxid und der oberflächennahen Siliciumschicht verwendet werden. Außer dem Plasmaätzen kann auch beim erfindungsgemäßen Verfahren das Sputterätzen verwendet werden.

0046886

Nach der in Fig. 2 dargestellten Strukturierung der polykristallinen Schicht 7 erfolgt eine ganzflächige Oxidation bei ca. 1000°C. Die durch den Ätzvorgang nicht entfernten Arsenionen diffundieren dabei entweder aus der Oxidschicht 3 oder aus oberflächennahen Schichten unterhalb der dünnen Oxidschicht 3 in das Innere des Halbleitersubstrats 1 und bilden dort den ersten dotierten Bereich 16. Der Bereich 16 ist somit selbstjustiert zu der polykristallinen Siliciumschicht 7 eingebracht.

Anschließend erfolgt die zweite Implantation z.B. mittels Borionen wie in Fig. 3 angedeutet, selbstjustierend, wobei die verbliebene polykristalline Schicht 7 diese Selbstjustierung bewirkt. Durch die Selbstjustierung entfallen Justiertoleranzen der sonst üblich verwendeten Fotomasken, wodurch die hiernach angefertigten Strukturen wesentlich kleiner gehalten werden können, was den Vorteil eines geringeren Flächenbedarfs am Halbleiterchip bewirkt. Danach erfolgt eine zunächst ganzflächige Abscheidung der zweiten polykristallinen dotierten Schicht 11, deren Dotierung und Strukturierung in ähnlicher Weise erfolgen kann wie bei der ersten polykristallinen Schicht 7. Bewirkt die Strukturierung der zweiten polykristallinen Siliciumschicht 11 Strukturen, wie sie in Fig. 4 oder Fig. 5 dargestellt sind, so erfolgt auch das Einbringen der dotierten Bereiche 14 und 15 selbstjustierend.

Das erfindungsgemäße Verfahren kann zur Herstellung dynamischer RAM-Speicher, insbesondere zur Herstellung von 64 K RAM-Speichern verwendet werden.

7 Patentansprüche
5 Figuren

Bezugszeichenliste

1   Halbleitersubstrat
2   Dioxidstrukturen
3   dünne Oxidschichten
4   Oberfläche
5   Pfeile
6   Siliciumoberflächenteile
7   polykristalline dotierte Siliciumschicht
8   Stufe
9   dünne Oxidschicht
10  Pfeile
11  zweite polykristalline, dotierte und
    strukturierte Siliciumschicht
12  Teil
13  Teil
14  zweiter dotierter Bereich
15  dritter dotierter Bereich
16  erster dotierter Bereich

## Patentansprüche

1. Verfahren zur Herstellung von in einem Halbleiterchip integrierten dynamischen RAM-Eintransistorspeicherzellen bestehend aus je einem integrierten Feldeffekttransistor und je einem integrierten Varaktor, bei dem mittels fotolithographisch vorgegebenem Muster an einer Halbleiteroberfläche die Oxidstrukturen in an sich bekannter Weise, z.B. mittels Locos-Verfahren angebracht werden,   d a -
d u r c h   g e k e n n z e i c h n e t,
daß eine erste Ionenimplantation, angedeutet durch die Pfeile (5), so erfolgt, daß die Dickoxidstrukturen (2) als Implantationsmaske dienen und daß zunächst eine erste Ionensorte ganzflächig implantiert wird, daß danach eine erste Schicht von dotiertem polykristallinem Halbleitermaterial ganzflächig auf der Oberfläche abgeschieden wird, daß danach die erste polykristalline Schicht mittels einer vorgegebenen Fotolackmaske, die in der Zeichnung nicht dargestellt ist, strukturiert wird, so daß die polykristalline, strukturierte Halbleiterschicht (7) entsteht, wobei an den freien Stellen der Fotolackmaske die darunter liegenden Schichten, die polykristalline Schicht, die Oxidschicht und, falls die erste Implantation in einer oberflächennahen Halbleiterschicht erfolgt, auch diese Halbleiterschicht, abgeätzt werden, daß danach die Fotomaske abgelöst wird, daß danach eine ganzflächige Oxidation sowohl der freien Halbleiteroberflächenteile wie der polykristallinen Halbleiterschicht erfolgt, so daß eine dünne Oxidschicht (9) entsteht, daß danach eine zweite bezüglich der Kanten der ersten polykristallinen Halbleiterschicht selbstjustierende, ganzflächige Ionenimplantation, angedeutet durch die Pfeile (10), erfolgt, daß danach eine zweite dotierte polykristalline Schicht ganzflächig abgeschieden wird,

Kus 1 Lk

daß danach die zweite polykristalline Halbleiterschicht durch eine geeignete Fototechnik strukturiert wird, so daß die polykristalline, strukturierte Halbleiterschicht (11) entsteht.

2. Verfahren nach Anspruch 1, d a d u r c h  g e k e n n - z e i c h n e t, daß die zweite polykristalline Halbleiterschicht so strukturiert wird, daß eine zusätzliche Diffusion oder Implantation in den Halbleitereinkristall (1) selbstjustierend bezüglich der Kanten der zweiten polykristallinen strukturierten Halbleiterschicht (11) und Kanten von Dickoxidstrukturen (2) sowie möglicherweise auch bezüglich der Kanten der ersten polykristallinen, strukturierten Halbleiterschicht (7) erfolgt.

3. Verfahren nach den Ansprüchen 1 oder 2, d a d u r c h  g e k e n n z e i c h n e t, daß die Dotierung der ersten und zweiten polykristallinen Schicht während oder nach der Abscheidung dieser Schichten erfolgt.

4. Verfahren nach einem der Ansprüche 1 bis 3, d a d u r c h  g e k e n n z e i c h n e t, daß die erste Implantation in den Halbleitereinkristall (1) oder aber in eine auf den zu implantierenden Bereichen abgeschiedene Oxidschicht (3 bzw. 9) mit nachfolgender Diffusion der implantierten Ionen in den Halbleitereinkristall (1) erfolgt.

5. Verfahren nach einem der Ansprüche 1 bis 4, d a d u r c h  g e k e n n z e i c h n e t, daß die erste Ionenimplantation, angedeutet durch die Pfeile (5), in den zu dotierenden Halbleiterbereichen einen Leitungstyp einer ersten Art erzeugt, während die zweite Ionenimplantation, angedeutet durch die Pfeile (10), in den zu dotierenden Bereichen einen Leitungstyp einer zweiten Art erzeugt, der dem Leitungstyp der ersten Art entgegengerichtet ist.

Kus 1 Lk

6. Verfahren nach einem der Ansprüche 1 bis 5, d a d u r ch
g e k e n n z e i c h n e t , daß als Halbleitermaterial
Silicium verwendet wird.

7. Verfahren nach einem der Ansprüche 1 bis 6, d a d u r ch
g e k e n n z e i c h n e t , daß als einkristallines
Halbleitermaterial p-leitendes Silicium und zur ersten
Implantation, angedeutet durch die Pfeile (5), eine Ionenart mit kleinem Diffusionskoeffizienten aus der fünften
Gruppe des periodischen Systems, z.B. Arsen verwendet
wird, während zur zweiten Implantation, angedeutet durch
die Pfeile (10), eine Ionenart aus der dritten Gruppe des
periodischen Systems, z.B. Bor, verwendet wird.

Kus 1 Lk/4.5.1981

FIG 1

FIG 2

FIG 3

FIG 4

FIG 5